# EUROPEAN PATENT APPLICATION

(11) **EP 2 148 356 A1**
(43) Date of publication of application: **27.01.2010**
(21) Application number: 09165948.2
(22) Date of filing: 21.07.2009
(51) Int. Cl.: H01J 17/28, H05K 7/20

(54) **Plasma display panel**

(30) Priority: 21.07.2008 KR 20080070793
(71) Applicant: Samsung SDI Co., Ltd., Gyeonggi-do (KR)
(72) Inventor: Lee, Hyun-YE, Gyeonggi-do (KR)
(74) Representative: Gulde Hengelhaupt Ziebig & Schneider

(57) **Abstract**

A plasma display panel (PDP) is disclosed. In one embodiment, the PDP includes i) a panel assembly comprising a first substrate and a second substrate coupled to the first substrate, ii) a chassis base attached to the panel assembly via a first surface thereof, iii) a plurality of circuit boards which are attached to a second surface of the chassis base and comprise a plurality of circuit elements mounted thereon, wherein the second surface faces away from the first surface and iv) a first graphite layer coated on at least part of the second surface of the chassis base. According to at least one embodiment, a graphite layer having a high thermal conductivity in a planar direction is prepared as a powder and is injected and coated onto an external surface of a chassis base in a liquid state, thereby allowing the entire chassis base to act as a heat dissipation plate.

## Description

### BACKGROUND OF THE INVENTION

### Field of the Invention

The present invention relates to a plasma display panel (PDP), and more particularly, to a PDP in which a graphite layer is coated on a surface of a chassis base.

### Description of the Related Technology

Generally, in a plasma display panel (PDP), a panel assembly is assembled by coupling a first substrate and a second substrate to each other, a chassis base is attached to a rear surface of the panel assembly, and a circuit board is mounted on the chassis base. Both terminals of a signal transmission unit are respectively connected to an electrode terminal of the panel assembly and a circuit element of the circuit board so that an electrical signal is communicated between the electrode terminal and the circuit board.

### SUMMARY OF CERTAIN INVENTIVE ASPECTS

One aspect of the present invention is a plasma display panel (PDP) with an improved structure, in which a graphite layer is coated on an external surface of a chassis base to promptly dissipate heat generated during an operation of the PDP to the outside.

Another aspect of the present invention is a PDP including: a panel assembly including a first substrate and a second substrate coupled to the first substrate; a chassis base attached to the panel assembly and supporting the panel assembly; and a plurality of circuit boards which are attached to a rear surface of the chassis base and have a plurality of circuit elements mounted thereon, wherein a first graphite layer is coated on an external surface of the chassis base.

The first graphite layer may be coated on a portion of a surface of the chassis base, which faces the circuit boards.

A signal transmission unit transferring an electrical signal between the panel assembly and the circuit board may be mounted on an end of the chassis base, and a second graphite layer may be further coated on a portion of an external surface of an end of the chassis base, which corresponds to a driving integrated circuit (IC) of the signal transmission unit.

A cover plate may be mounted behind the signal transmission unit, the signal transmission unit may be disposed between the chassis reinforcing member and the cover plate, and a third graphite layer may be coated on a portion of an inner surface of the cover plate, which corresponds to the driving IC of the signal transmission unit.

The first graphite layer may be coated on an entire surface of the chassis base.

An anodizing coating film layer may be formed on at least one of a surface of the chassis base, an external surface of an end of the chassis base, an inner surface of the cover plate, an inner surface of the chassis reinforcing member and an external surface of the heat sink, which face the first through the fifth graphite layers, respectively.

Another aspect of the invention is a plasma display panel (PDP) comprising: a panel assembly comprising a first substrate and a second substrate coupled to the first substrate; a chassis base attached to the panel assembly via a first surface thereof; a plurality of circuit boards which are attached to a second surface of the chassis base and comprise a plurality of circuit elements mounted thereon, wherein the second surface faces away from the first surface; and a first graphite layer coated on at least part of the second surface of the chassis base.

In the above PDP, the first graphite layer may be coated on a portion of the second surface of the chassis base, which faces the circuit boards. The above PDP may further comprise: a signal transmission unit connected to an end of the chassis base and configured to transmit an electrical signal between the panel assembly and the circuit boards; and a second graphite layer coated on at least part of an end of the chassis base, which faces the signal transmission unit.

The above PDP may further comprise: a cover plate connected to a portion of the signal transmission unit, wherein the cover plate at least partially covers the signal transmission unit; and a third graphite layer coated on at least part of an inner surface of the cover plate, which faces the signal transmission unit. The above PDP may further comprise: a chassis reinforcing member disposed on a lengthwise end of the chassis base; a signal transmission unit connected to an end of the chassis base and configured to transmit an electrical signal between the panel assembly and the circuit boards; and a fourth graphite layer coated on at least part of an external surface of the chassis reinforcing member, which faces the signal transmission unit.

The above PDP may further comprise: a cover plate connected to a portion of the signal transmission unit, wherein the cover plate at least partially covers the signal transmission unit; and a third graphite layer coated on at least part of an inner surface of the cover plate, which faces the signal transmission unit.

In the above PDP, each of the circuit elements may include a heat sink coupled thereto, and the PDP may further comprise a fifth graphite layer coated on an external surface of the heat sink. In the above PDP, the first graphite layer may be coated on the entire external surface of the chassis base. In the above PDP, the chassis base may comprise a bent portion which faces away from the panel assembly, and the first graphite layer may be at least partially coated on a surface of the bent portion of the chassis base. In the above PDP, the thickness of the first graphite layer is preferably less than or equal to about 100 micrometers. The above PDP may further comprise an anodizing coating film layer formed between the second surface of the chassis base and the first graphite layer.

Another aspect of the invention is a plasma display panel (PDP) comprising: a chassis base configured to support a panel assembly via a first surface thereof, wherein the chassis base comprises a bent portion which faces away from the panel assembly; a plurality of circuit boards attached to a second surface of the chassis base, wherein the second surface faces away from the first surface, and wherein each of the plurality of circuit boards comprises a plurality of circuit elements mounted thereon; a signal transmission unit connected to an end of the chassis base and configured to transmit an electrical signal between the panel assembly and the circuit boards; a cover plate connected to a portion of the signal transmission unit, wherein the cover plate at least partially covers the signal transmission unit; a chassis reinforcing member configured to reinforce the chassis base, wherein the chassis reinforcing member is disposed between the signal transmission unit and the chassis base; and an anodizing coating film layer formed on at least one of the following: i) at least part of the second surface of the chassis base, ii) at least part of an external surface of the bent portion of the chassis base, iii) an inner surface of the cover plate which faces the signal transmission unit and iv) an external surface of the chassis reinforcing member which faces the signal transmission unit.

The above PDP may further comprise a graphite layer formed on the anodizing coating film layer. The above PDP may further comprise: a heat sink coupled to each of the circuit elements; and another anodizing coating film layer formed on an external surface of the heat sink.

Still another aspect of the invention is a plasma display panel (PDP) comprising: a chassis base configured to support a panel assembly via a first surface thereof, wherein the chassis base comprises a bent portion which faces away from the panel assembly, and wherein the bent portion comprises a third surface; a plurality of circuit boards attached to a second surface of the chassis base, wherein the second surface faces away from the first surface, and wherein each of the plurality of circuit boards comprises a plurality of circuit elements mounted thereon; a first anodizing coating film layer formed on at least part of the second and third surfaces of the chassis base; and a first graphite layer formed on the first anodizing coating film layer.

The above PDP may further comprise: a signal transmission unit connected to an end of the chassis base and configured to transmit an electrical signal between the panel assembly and the circuit boards; a cover plate connected to a portion of the signal transmission unit, wherein the cover plate at least partially covers the signal transmission unit; a chassis reinforcing member configured to reinforce the chassis base, wherein the chassis reinforcing member is bent at least once and disposed between the signal transmission unit and the chassis base; and a heat sink coupled to each of the circuit elements.

The above PDP may further comprise: a second anodizing coating film layer formed on a surface of the cover plate which faces the signal transmission unit; a third anodizing coating film layer formed on a surface of the chassis reinforcing member which faces the signal transmission unit; and a fourth anodizing coating film layer formed on a surface of the heat sink. The above PDP may further comprise: a second graphite layer formed on the second anodizing coating film layer; a third graphite layer formed on the third anodizing coating film layer; and a fourth graphite layer formed on the fourth anodizing coating film layer. In the above PDP, the thickness of the first graphite layer is preferably less than or equal to about 100 micrometers. In the above PDP, the first graphite layer preferably has a thermal conductivity of about 240 W/(m·K) or more.

### BRIEF DESCRIPTION OF THE DRAWINGS

FIG. 1 is a perspective view of a plasma display panel (PDP) according to an embodiment of the present invention.

FIG. 2 is a cross perspective view of the PDP taken along a line I-I of FIG. 1, for illustrating how the PDP is assembled.

FIG. 3 is a cross-sectional view of a PDP according to another embodiment of the present invention.

FIG. 4 is a cross-sectional view of a PDP according to another embodiment of the present invention.

### DETAILED DESCRIPTION OF CERTAIN INVENTIVE EMBODIMENTS

Generally, in order to reinforce the strength of the chassis base or to dissipate heat generated by a signal transmission unit, a circuit element, etc., a PDP includes a reinforcing means with high heat dissipation properties, such as a chassis reinforcing member. However, the typical PDP has the following problems.

First, the chassis base and the chassis reinforcing member may be bent due to a difference between their thermal expansion coefficients.

That is, the chassis base is formed of a steel material in order to reduce manufacturing costs. On the other hand, the chassis reinforcing member is formed of an aluminum material with a higher thermal conductivity and at a higher cost than the steel material.

At this time, the chassis reinforcing member is coupled to the chassis base by toxing which is similar to riveting. In this regard, the chassis base might bend since the chassis reinforcing member and the chassis base are formed of materials having different thermal expansion coefficients.

Second, as signal transmission units such as tape carrier packages (TCPs) have been reduced in thickness, more heat is generated by a driving integrated circuit (IC) in the signal transmission units. Accordingly, there is a need to promptly dissipate heat generated by the driving IC to the outside.

Third, when the driving IC, which generates a large amount of heat, contacts an external surface of the chassis reinforcing member, the length and thickness of the chassis reinforcing member need to be increased, thereby increasing manufacturing costs.

Fourth, the size of a heat sink, which contacts a circuit element to dissipate heat, is increased due to thermal runaway of the circuit element, and thus it is difficult to reduce the thickness of PDPs.

Hereinafter, embodiments of the present invention will be described with reference to the attached drawings.

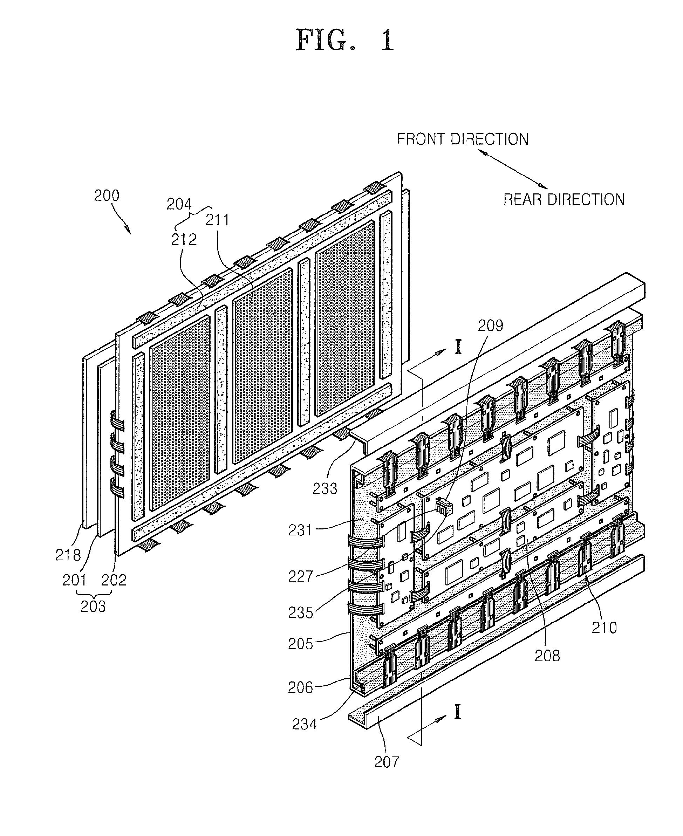

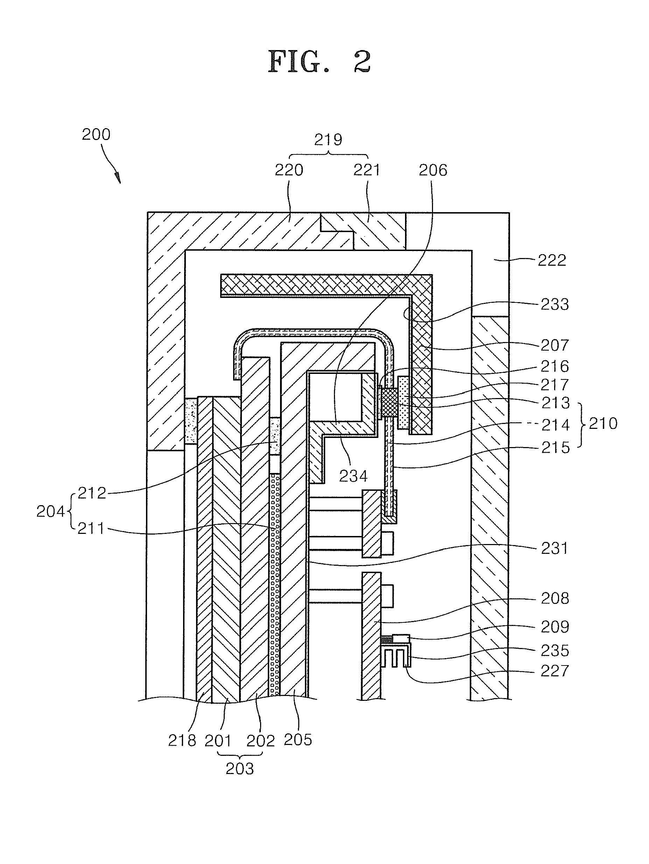

FIG. 1 is a perspective view of a plasma display panel (PDP) 200 according to an embodiment of the present invention. FIG. 2 is a cross-sectional view of the PDP 200 taken along a line I-I of FIG. 1, for illustrating how the PDP 200 is assembled.

Referring to FIGS. 1 and 2, the PDP 200 includes a panel assembly 203 including a first substrate 201 and a second substrate 202 coupled to the first substrate 201.

A chassis base 205 is attached to a rear surface of the panel assembly 203 by an adhesive member 204. The adhesive member 204 may include double-sided adhesive tapes 212 and a heat dissipation sheet 211 as shown in Figures 1-4. However, the adhesive member does not need to include both of the double-sided adhesive tapes 212 and the heat dissipation sheet 211 for attaching a chassis base 205 to a rear surface of the panel assembly 203. That is, the adhesive member 204 may include at least one of the double-sided adhesive tapes 212 and the heat dissipation sheet 211. For example, it is possible to use only the double-sided adhesive tapes 212 as an adhesive member. Further, it is possible to use only the heat dissipation sheet 211 as an adhesive member. If the heat dissipation sheet 211 is used as an adhesive member, the heat dissipation sheet 211 can have an adhesive function. The heat dissipation sheet 211 is interposed between a rear surface of the second substrate 202 and a front surface of the chassis base 205. The heat dissipation sheet 211 may be attached directly onto the rear surface of the second substrate 202 so as to dissipate heat generated by the panel assembly 203. On the other hand, an interval serving as a path along which air flows may be provided between the heat dissipation sheet 211 and the chassis base 205.

The heat dissipation sheet 211 may be formed of a material selected from the group consisting of a thick film type sheet (e.g., a silicon sheet, an acryl sheet or an urethane sheet) with high heat dissipation properties, a thick film type metal sheet (e.g., copper or aluminum) having a high thermal conductivity, a thick film type carbon-based sheet, a thick film sheet formed of a heat-conductive resin and a thick film type formed of a composite material. The heat dissipation sheet 211 formed of the above-described material is attached to the rear surface of the second substrate 202 by an adhesive layer (not shown).

A plurality of double-sided adhesive tapes 212 used to fix the chassis base 205 to the panel assembly 203 are attached to a portion of the rear surface of the second substrate 202, to which the heat dissipation sheet 211 is not attached.

Chassis reinforcing members 206 are each attached to upper and lower portions of a rear surface of the chassis base 205. Cover plates 207 are each mounted behind the upper and lower portions of the rear surface of the chassis base 205. A plurality of circuit boards 208 are mounted on the rear surface of the chassis base 205. A plurality of circuit elements 209 are mounted on the circuit board 208.

Signal transmission units 210 are mounted behind ends of the chassis base 205. One end of the signal transmission unit 210 is connected to discharge electrode terminals of the panel assembly 203, and the other end of the signal transmission unit 210 is connected to the circuit elements 209. Accordingly, an electrical signal is transmitted between the panel assembly 203 and the circuit boards 208.

The signal transmission unit 210 may include a plurality of driving integrated circuits (ICs) 213, a lead 214 that is electrically connected to the driving IC 213, and a flexible film 215 covering the lead 214.

The signal transmission unit 210 is disposed in a space between the chassis base 205 and the cover plate 207. Thermal grease 216 is interposed between the chassis reinforcing member 206 and the driving IC 213. A silicon sheet 217 is interposed between the driving IC 213 and the cover plate 207.

A filter assembly 218 is attached directly onto a front surface of the panel assembly 203. The filter assembly 218 is mounted in order to prevent electromagnetic waves or neon light generated by the panel assembly 203 from being emitted and to prevent external light from being reflected.

The panel assembly 203, the chassis base 205, the circuit boards 208 and the filter assembly 218 are accommodated by a case 219. The case 219 includes a front cabinet 220 mounted in front of the filter assembly 218 and a back cover 221 mounted behind the circuit boards 208. A plurality of through holes 222 are formed in upper and lower ends of the back cover 221.

In one embodiment, a graphite layer is coated on at least a portion of an external surface of the chassis base 205, wherein the graphite layer is used to promptly dissipate heat generated during an operation of the PDP 200 to the outside, which will now be described in more detail.

A first graphite layer 231 is coated on an external surface of the chassis base 205. The first graphite layer 231 is coated on a portion of the external surface of the chassis base 205, which faces the circuit boards 208. However, the present invention is not limited thereto. That is, the first graphite layer 231 may be coated on an entire surface of the chassis base 205, or may be partially coated on a predetermined region of the chassis base 205, where a large amount of heat is generated.

In one embodiment, the first graphite layer 231 is coated as a thin film type on the chassis base 205 by injection, unlike in the case where the heat dissipation sheet 211 is attached as a thick film type onto the rear surface of the second substrate 202.

In one embodiment, the first graphite layer 231 is formed as follows. A raw material of graphite is prepared in a powder state. The raw material is mixed with a hardening agent in a ratio of about 97 % : 3% to about 98% : 2% and thus changes to a liquid state. Then, the result of the mixing is injected onto an external surface of the chassis base 205 by using a spray coating apparatus. After injecting the result of the mixing, it is dried such that the hardening agent evaporates, thereby completing the first graphite layer 231 formed of only the raw material graphite.

In one embodiment where a thick film graphite sheet is used, adhesives are interposed between the thick film graphite sheet and the chassis base 205 in order to attach the thick film graphite sheet to the chassis base 205. However, in the first graphite layer 231 according to one embodiment of the present embodiment, a raw material graphite in a liquid state is injected so as to be attached to the chassis base 205, and the raw material graphite is dried so that only the raw material is left, thereby obtaining a high thermal conductivity.

The first graphite layer 231 may be coated to a thickness less than or equal to about 100 micrometers, for example, to maintain good thermal resistance.

In one embodiment, the first graphite layer 231 having a thermal conductivity of about 240 W/(m·K) or more is coated to a thickness less than or equal to about 100 micrometers so as to be a thin film type on the entire surface or at least a portion of the chassis base 205, which faces the circuit board 208, thereby improving the heat dissipation properties of the chassis base 205 in horizontal and vertical directions.

A thin film type graphite layer may also be formed on a portion of a surface of the chassis base 205, which faces the panel assembly 203, by injecting a raw material graphite in a liquid state. In this case, the thin film graphite layer may contact a thick film type heat dissipation sheet 211, which is interposed between the panel assembly 203 and the chassis base 205, thereby forming a double-layered structure, or may alternatively form a single-layer structure constituting the first graphite layer 231 without the heat dissipation sheet 211.

In addition, the cover plate 207 has a length corresponding to a lengthwise side of the chassis base 205. The cover plate 207 is bent at least once such that the cover plate 207 and the chassis base 205 define an inner space when the cover plate 207 is coupled to an end of the chassis base 205. The signal transmission unit 210 is disposed in the inner space.

At this time, a third graphite layer 233 is coated on the bent inner surface of the cover plate 207. The third graphite layer 233 is coated on a surface of the cover plate 207, which corresponds to the driving ICs 213 of the signal transmission unit 210. The third graphite layer 233 may be formed of substantially the same material as the first graphite layer 231.

Likewise, since the silicon sheet 217 and the third graphite layer 233 are stacked between the cover plate 207 and the driving ICs 213, heat generated by the driving ICs 213 during the operation of the PDP 200 is transmitted through the silicon sheet 217 and the third graphite layer 233, and is dissipated via the cover plate 207 to the outside, thereby improving heat dissipation properties. Alternatively, the silicon sheet 217 may not be used.

In addition, the chassis reinforcing member 206 has a length corresponding to the lengthwise side of the chassis base 205 and is attached to a rear surface of the chassis base 205 so as to reinforce the strength of the chassis base 205.

In this case, a fourth graphite layer 234 is further coated on an external surface of the chassis reinforcing member 206. The fourth graphite layer 234 is coated on a portion of a surface of the chassis reinforcing member 206, which corresponds to the driving ICs 213 of the signal transmission unit 210. The fourth graphite layer 234 may be formed of substantially the same material as the first graphite layer 231.

Likewise, since the fourth graphite layer 234 and the thermal grease 216 are stacked between the chassis reinforcing member 206 and the driving ICs 213, heat generated by the driving ICs 213 during the operation of the PDP 200 is transmitted through the thermal grease 216 and the fourth graphite layer 234, and is transmitted to the chassis reinforcing member 206 and the chassis base 205, thereby improving the heat dissipation properties. Alternatively, the thermal grease 216 may not be used.

In addition, the circuit element 209, which generates a large amount of heat, such as a field effect transistor (FET), from among circuit elements mounted on the circuit board 208 contacts an external surface of a heat sink 227 so as to dissipate generated heat to the outside.

At this time, a fifth graphite layer 235 is coated on the external surface of the heat sink 227. The fifth graphite layer 235 is coated on the external surface of the heat sink 227 in contact with the circuit element 209. The fifth graphite layer 235 may be formed of substantially the same material as the first graphite layer 223.

Likewise, since the fifth graphite layer 235 is coated between the circuit element 209 and the heat sink 227, heat generated by the circuit element 209 is transmitted through the fifth graphite layer 235 and is transmitted through the heat sink 227, thereby dissipating heat to the outside.

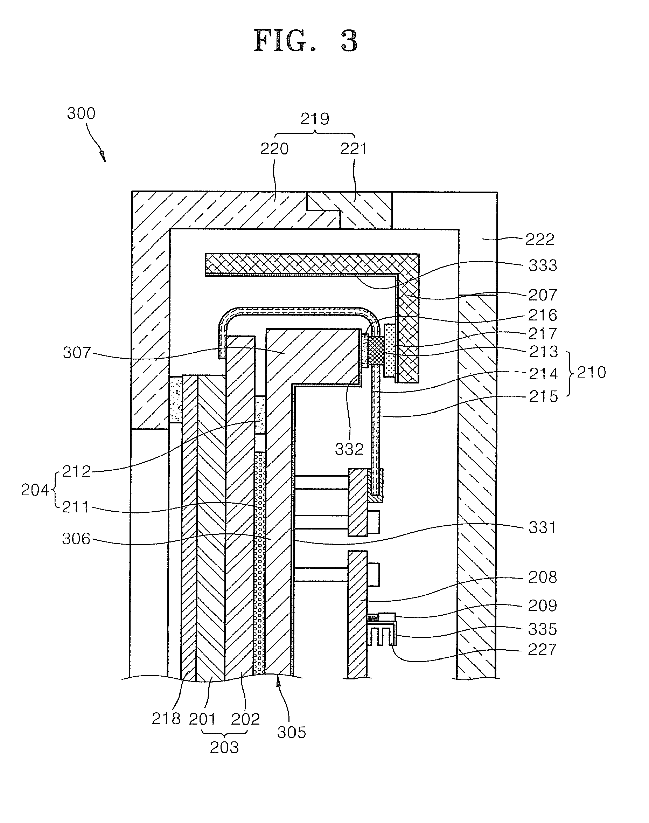

FIG. 3 is a cross-sectional view of a PDP 300 according to another embodiment of the present invention.

Hereinafter, the same numerals in FIGS. 1 through 3 denote the same element serving the same function, and thus only primary elements will be described.

Referring to FIG. 3, a chassis base 305 is attached to a rear surface of a panel assembly 203 by an adhesive member 204. The chassis base 305 includes a body unit 306 having a plate shape, which is formed on the chassis base 305 in a direction substantially parallel to the panel assembly 203, wherein an end 307 of the body unit 306 is bent towards a direction in which circuit boards 208 are disposed.

A first graphite layer 331 is coated on an external surface of the body unit 306. The first graphite layer 331 is coated on a portion of a surface of the body unit 306, which faces the circuit boards 208. However, the present invention is not limited thereto. That is, the first graphite layer 331 may be coated on an entire surface of the body unit 306, or may be partially coated on a predetermined region of the body unit 306, which generates a significant amount of heat.

In one embodiment, the first graphite layer 331 is formed as follows. A raw material of graphite is prepared in a powder state. The raw material is mixed with a hardening agent in a ratio of about 97% : 3% to about 98% : 2% and thus changes to a liquid state. Then, the result of the mixing is injected onto an external surface of the body unit 306 to a thickness less than or equal to about 100 micrometers and is dried, thereby completing the first graphite layer 331.

A second graphite layer 332 is further coated on an external surface of an end 307 of the chassis base 305. The second graphite layer 332 is coated on a portion of the external surface of the end 307 of the chassis base 305, which corresponds to driving ICs 213 of the signal transmission unit 210. From a manufacturing process point of view, the second graphite layer 332 may be formed of substantially the same material as the first graphite layer 331, and may be simultaneously formed on a surface of the body unit 306 when the first graphite layer 331 is coated on the surface of the body unit 306.

Likewise, since the second graphite layer 332 and the thermal grease 216 are stacked between the end 307 of the chassis base 305 and the driving ICs 213, heat generated by the driving ICs 213 during an operation of the PDP 300 is transmitted through the thermal grease 216 and the second graphite layer 332, and is dissipated via the chassis base 305 to the outside.

A cover plate 207 is mounted behind the end 307 of the chassis base 305. A third graphite layer 333 is coated on a portion of a surface of the cover plate 207, which corresponds to the driving ICs 213 of the signal transmission unit 210.

Likewise, since a silicon sheet 217 and the third graphite layer 333 are stacked between the cover plate 207 and the driving ICs 213, heat generated by the driving ICs 213 during the operation of the PDP 300 is dissipated via the silicon sheet 217, the third graphite layer 333 and the cover plate 207 to the outside, thereby improving heat dissipation properties.

In addition, a fifth graphite layer 335 is coated on a portion of an external surface of a heat sink 227, which contacts a circuit element 209 having a large heating value, such as an FET, from among circuit elements mounted on the circuit board 208.

Since the fifth graphite layer 335 is coated between the circuit element 209 and the heat sink 227, heat generated by the circuit element 209 is transmitted through the fifth graphite layer 335, is transmitted to the heat sink 227, and then is dissipated to the outside.

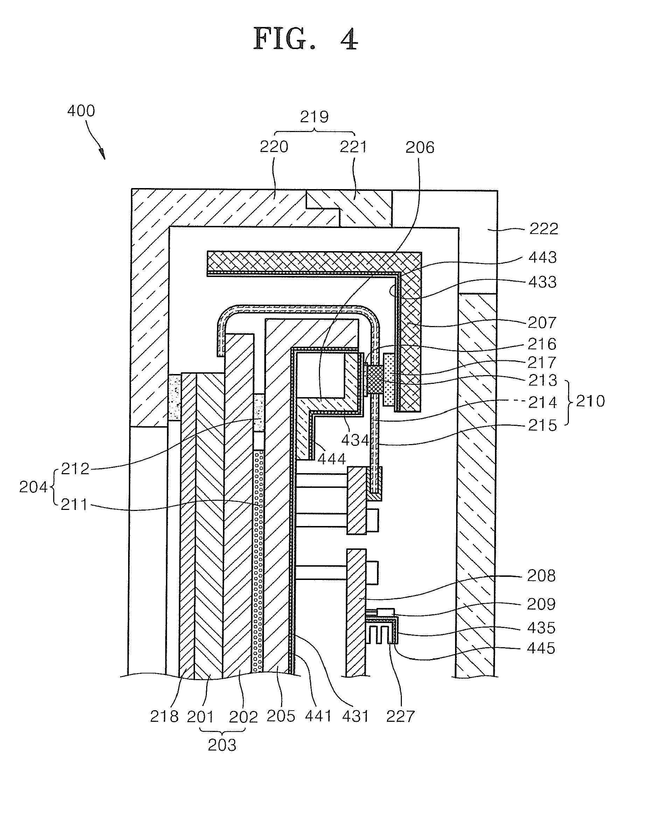

FIG. 4 is a cross-sectional view of a PDP 400 according to another embodiment of the present invention.

Referring to FIG. 4, a first graphite layer 431 is coated on an external surface of a chassis base 205. The first graphite layer 431 is coated on a portion of the surface of the chassis base 204, which faces circuit boards 208. The first graphite layer 431 may be formed by injecting raw material graphite in a liquid state.

A cover plate 207 is mounted behind an end of the chassis base 205. A third graphite layer 433 is coated on an inner surface of the cover plate 207. The third graphite layer 433 is coated on a portion of a surface of the cover plate 207, which corresponds to driving ICs 213 of a signal transmission unit 210.

Chassis reinforcing members 206 are each attached to upper and lower portions of a rear surface of the chassis base 205. A fourth graphite layer 434 is coated on an external surface of the chassis reinforcing member 206. The fourth graphite layer 434 is coated on a portion of a surface of the chassis reinforcing member 206, which corresponds to the driving ICs 213 of the signal transmission unit 210.

A fifth graphite layer 435 is coated on a portion of an external surface of a heat sink 227, which contacts a circuit element 209 such as an FET.

Anodizing coating film layers 441, 443, 444 and 445 may be formed on at least one of a surface of the chassis base 205, a surface of the cover plate 207, a surface of the chassis reinforcing member 206 and a surface of the heat sink 227, by anodizing. When the chassis reinforcing member 206 is not mounted, an anodizing coating film layer may also be formed on an end of the chassis base 205.

Accordingly, the anodizing coating film layer 441 and the first graphite layer 431 are stacked on a surface of the chassis base 205. The anodizing coating film layer 443 and the third graphite layer 433 are stacked on an inner surface of the cover plate 207. The anodizing coating film layer 444 and the fourth graphite layer 434 are stacked on an external surface of the chassis reinforcing member 206. The anodizing coating film layer 445 and the fifth graphite layer 435 are stacked on an external surface of the heat sink 227. Thus, heat generated by various heat sources in the PDP 300 can be radiated by the anodizing coating film layers 441, 443, 444 and 445, thereby maximizing the heat dissipation properties.

In one embodiment, only anodizing coating film layers 441, 443, 444 and 445 are used without graphite layers. In another embodiment, graphite layers are formed on the anodizing coating film layers 441, 443, 444 and 445.

Table 1 shows the temperatures of a typical chassis base and a chassis base according to one embodiment of the invention.

**Table 1**

| | Comparative example | Example |
|---|---|---|
| Graphite layer | Not included | Included |
| Temperature of chassis base | 47 °C | 43.3 °C |

The example of Table 1 is related to the case where a graphite layer is coated on an external surface of a chassis base, according to an embodiment of the present invention. The comparative example of Table 1 is related to the case where a graphite layer is not coated on an external surface of a typical chassis base.

Referring to Table 1, in the comparative example, the temperature of the chassis base is 47 °C. On the other hand, in the example, the temperature of the chassis base is 43.3 °C since the graphite layer is coated thereon. Thus, it can be seen that by coating the graphite layer onto the chassis base the temperature of the chassis base is reduced by 3.7 °C.

According to at least one embodiment of the present invention, a PDP can achieve the following advantages.

First, a graphite layer having a high thermal conductivity in a planar direction is prepared as a powder and is injected and coated onto an external surface of a chassis base, in a liquid state, thereby allowing the entire chassis base to act as a heat dissipation plate.

Second, by coating a graphite layer onto external surfaces of a chassis reinforcing member, cover plate and heat sink, it is easy to dissipate heat to the outside.

Third, an anodizing coating film layer is formed by anodizing, thereby maximizing heat dissipation properties due to not only transmission and convection of heat generated by heating sources, but also radiation of heat by anodizing.

### SUMMARY OF INVENTION

The invention relates to a plasma display panel (PDP) comprising a chassis base attached to a panel assembly via a first surface thereof and a plurality of circuit boards which are attached to a second surface of the chassis base and comprise a plurality of circuit elements mounted thereon. The PDP may include a signal transmission unit connected to an end of the chassis base and configured to transmit an electrical signal between the panel assembly and the circuit boards, a cover plate connected to a portion of the signal transmission unit, wherein the cover plate at least partially covers the signal transmission unit and a chassis reinforcing member disposed on a lengthwise end of the chassis base, and each of the circuit elements may include a heat sink coupled thereto. An anodizing coating film layer and/or a graphite layer is coated on at least one of the second surface of the chassis base, an external surface of a bent portion of the chassis base, an end of the chassis base which faces the signal transmission unit, an inner surface of the cover plate which faces the signal transmission unit, an external surface of the chassis reinforcing member which faces the signal transmission unit, and an external surface of the heat sink, thereby increasing heat dissipation. Where both a graphite film and an anodizing coating film layer are formed on the same surface, the graphite layer is formed on the anodizing coating film layer. The graphite layer may have a thickness less than or equal to about 100 micrometers and a thermal conductivity of about 240 W/(m•K) or more.

## Claims

1. A plasma display panel (PDP) comprising:
a chassis base attached to a panel assembly via a first surface thereof;
a plurality of circuit boards which are attached to a second surface of the chassis base and comprise a plurality of circuit elements mounted thereon; and
a first graphite layer coated on at least part of the second surface of the chassis base.

2. The PDP of claim 1, wherein the thickness of the first graphite layer is less than or equal to about 100 micrometers.

3. The PDP of any one of the preceding claims, wherein the first graphite layer has a thermal conductivity of about 240 W/(m·K) or more.

4. The PDP of any one of the preceding claims , wherein the first graphite layer is coated on a portion of the second surface of the chassis base which faces the circuit boards.

5. The PDP of any one of the preceding claims, wherein the first graphite layer is coated on the entire external surface of the chassis base.

6. The PDP of any one of the preceding claims, wherein the chassis base comprises a bent portion which faces away from the panel assembly, and wherein the first graphite layer is at least partially coated on a surface of the bent portion of the chassis base.

7. The PDP of any one of the preceding claims, further comprising a first anodizing coating film layer formed between at least one surface of the chassis base and the first graphite layer.

8. The PDP of any one of the preceding claims, further comprising:
a signal transmission unit connected to an end of the chassis base and configured to transmit an electrical signal between the panel assembly and the circuit boards; and
a second graphite layer coated on at least part of an end of the chassis base, which faces the signal transmission unit.

9. The PDP of claim 8, further comprising:
a cover plate connected to a portion of the signal transmission unit, wherein the cover plate at least partially covers the signal transmission unit; and
a third graphite layer coated on at least part of an inner surface of the cover plate, which faces the signal transmission unit.

10. The PDP of any one of the preceding claims, further comprising:
a chassis reinforcing member disposed on a lengthwise end of the chassis base;
a signal transmission unit connected to an end of the chassis base and configured to transmit an electrical signal between the panel assembly and the circuit boards; and
a fourth graphite layer coated on at least part of an external surface of the chassis reinforcing member, which faces the signal transmission unit.

11. The PDP of any one of the preceding claims, wherein each of the circuit elements includes a heat sink coupled thereto, and
wherein the PDP further comprises a fifth graphite layer coated on an external surface of the heat sink.

12. The PDP of one of claims 9 to 11, further comprising:
a second anodizing coating film layer formed on a surface of the cover plate which faces the signal transmission unit; and/or
a third anodizing coating film layer formed on a surface of the chassis reinforcing member which faces the signal transmission unit; and/or
a fourth anodizing coating film layer formed on a surface of the heat sink,
wherein where both a graphite film and an anodizing coating film layer are formed on the same surface, the graphite layer is formed on the anodizing coating film layer.

13. A plasma display panel (PDP) comprising:
a chassis base configured to support a panel assembly via a first surface thereof, wherein the chassis base comprises a bent portion which faces away from the panel assembly;
a plurality of circuit boards attached to a second surface of the chassis base, wherein the second surface faces away from the first surface, and wherein each of the plurality of circuit boards comprises a plurality of circuit elements mounted thereon;
a signal transmission unit connected to an end of the chassis base and configured to transmit an electrical signal between the panel assembly and the circuit boards;
a cover plate connected to a portion of the signal transmission unit, wherein the cover plate at least partially covers the signal transmission unit;
a chassis reinforcing member configured to reinforce the chassis base, wherein the chassis reinforcing member is disposed between the signal transmission unit and the chassis base; and
an anodizing coating film layer formed on at least one of the following: i) at least part of the second surface of the chassis base, ii) at least part of an external surface of the bent portion of the chassis base, iii) an inner surface of the cover plate which faces the signal transmission unit and iv) an external surface of the chassis reinforcing member which faces the signal transmission unit.

14. The PDP of claim 12, further comprising a graphite layer formed on the anodizing coating film layer.

15. The PDP of claim 12, further comprising:
a heat sink coupled to each of the circuit elements; and
another anodizing coating film layer formed on an external surface of the heat sink.
